Europäisches Patentamt

(19) European Patent Office

Office européen des brevets

(11) Publication number: **0 052 475**

**A2**

## (12) EUROPEAN PATENT APPLICATION

(21) Application number: **81305345.1**

(22) Date of filing: **11.11.81**

(51) Int. Cl.³: **H 01 L 29/78**
**H 01 L 23/52, H 01 L 27/08**
**H 01 L 21/70, H 01 L 21/00**

(30) Priority: **19.11.80 JP 162936/80**
**19.11.80 JP 162937/80**

(43) Date of publication of application:
**26.05.82 Bulletin 82/21**

(84) Designated Contracting States:
**DE FR GB**

(71) Applicant: **TOKYO SHIBAURA DENKI KABUSHIKI KAISHA**
**72, Horikawa-cho Saiwai-ku**
**Kawasaki-shi Kanagawa-ken 210(JP)**

(72) Inventor: **Sato, Masashi**
**5-21-37, Tsunashimanishi**
**Kohoku-ku Yokohama-shi(JP)**

(72) Inventor: **Ishibashi, Masayuki**
**4-31, Toshiba-Sugita-corpo 2952 Tomioka**
**Kanazawa-ku Yokohama-shi(JP)**

(72) Inventor: **Kobayashi, Ichiro**
**1123 Shimoda-cho**
**Kohoku-ku Yokohama-shi(JP)**

(74) Representative: **Freed, Arthur Woolf et al,**
**MARKS & CLERK 57-60 Lincoln's Inn Fields**
**London WC2A 3LS(GB)**

(54) **Semiconductor device and method for manufacturing the same.**

(57) A semiconductor device comprising a semiconductor element formed in a semiconductor region (200) of a first conductivity type with a gate electrode (222) made of refractory metal and an impurity region (226, 228).

An insulating layer (218) is formed, at least partially buried, in a given region of the semiconductor region (200). Formed on the insulating layer is a metal interconnection layer (224) integral with the gate electrode made of refractory metal. In the semiconductor region right under the insulating layer (218), an impurity diffusion layer (214) having impurity of a second conductivity type is formed in contact with the insulating layer (218).

FIG. 8E

- 1 -

Semiconductor device and method for
manufacturing the same

The present invention relates to a semiconductor
device and a method for manufacturing the same.

In a semiconductor device with a gate electrode
made of, for example, polysilicon or refractory metal
(referred to as a polysilicon gate type semiconductor
device), its source and drain regions are generally
formed in a self-alignment fashion, with a mask of the
gate electrode. Accordingly, this type semiconductor
device can improve an integration density, compared to
a semiconductor device with a gate electrode made of
nonrefractory metal such as aluminum. In case where the
polysilicon gate is extended to use as a interconnection,
however, it is impossible to diffuse impurity under the
polysilicon gate interconnection as the polysilicon gate
interconnection serves as a mask. Because of this, the
polysilicon gate interconnection can not be crossed
with the impurity layer. Therefore, the semiconductor
device is still accompanied by the drawback of the poor
integration density in the semiconductor device. The
drawback may be eliminated in a manner that before the
polysilicon gate interconnection is formed, the impurity
diffusion layer is formed by introducing impurity into
the semiconductor region where the polysilicon gate
interconnection is to be formed. Generally, a thin film having same thickness as a gate oxide film is formed under the polysilicon gate interconnection, so that an interconnection capacity is increased to prevent a satisfactory improvement of an operation speed of the semiconductor device. To cope with this problem, the polysilicon gate interconnections are normally terminated at a proper location and connected with aluminum interconnections, for example, interposed therebetween.

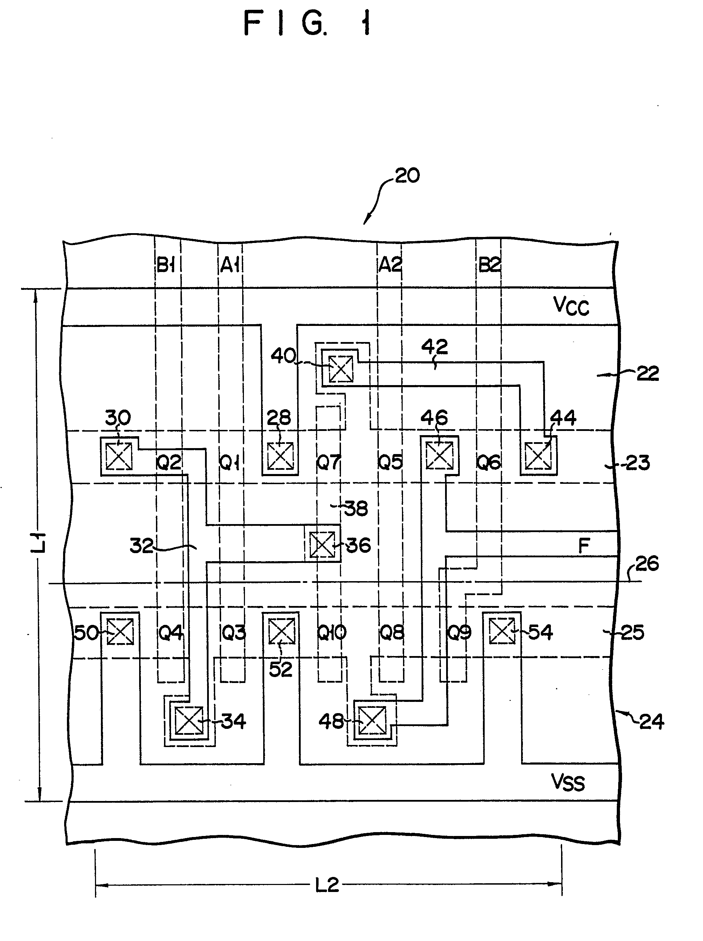

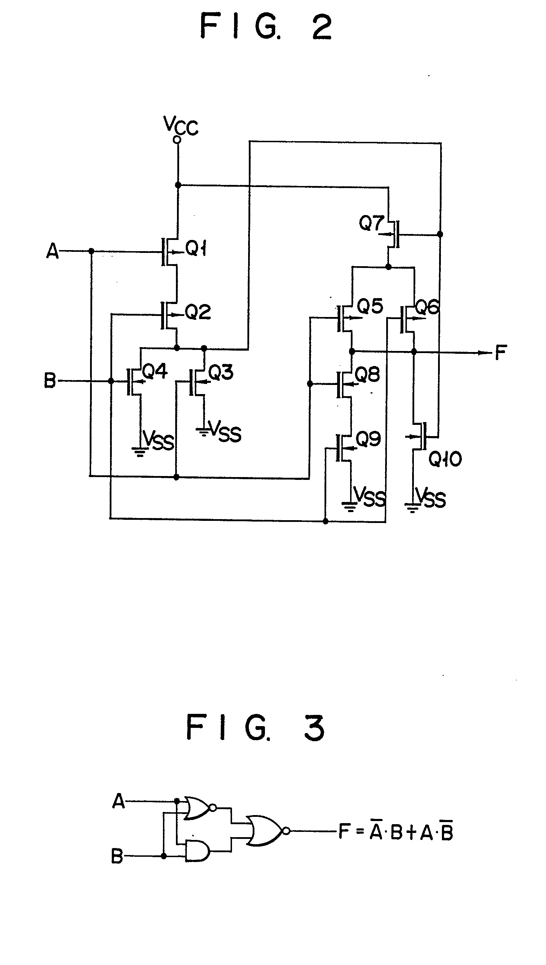

An example of a semiconductor device formed by a prior art method will be described referring to Figs. 1 to 3. Fig. 1 is a plan view of a prior art complementary semiconductor device 20, Fig. 2 a circuit diagram of the semiconductor device 20, and Fig. 3 a logic expression of the circuit of Fig. 2. The complementary semiconductor device 20 is comprised of P channel transistors Q1, Q2, Q5, Q6 and Q7 formed in an element group region 23 of a semiconductor substrate 22, and N channel transistors Q3, Q4, Q8, Q9 and Q10 formed in another element group region 25 of a P-well region 24. A boundary between the P-well region 24 and the N type semiconductor substrate 22 is indicated by a line 26. The sources of the P channel transistors Q1 and Q7 are connected to a power source line Vcc by means of a contact 28, and a drain of the transistor Q1 is connected to a source of the transistor Q2. A drain of the transistor Q2 is connected to an aluminum interconnection 32 by means of a contact 30. The aluminum interconnection 32 is connected to drains of the transistors Q3 and Q4 by means of contact 34 and to gate interconnection 38 of the transistors Q7 and Q10 by a contact 36. A drain of the transistor Q7 is connected to a source of the transistor Q5 and to an aluminum interconnection 42 by means of a contact 40. The aluminum interconnection 42 is connected to a source of the transistor Q6 by means of a contact 44. Drains of the transistors Q5 and Q6 are connected to an output wiring F of a complementary semiconductor device 20. The output wiring F is connected to drains of the transistors Q8 and Q10 by means of a contact 48. Further, a ground line Vss is connected to a source of the transistor Q4 by means of a contact 50 and to sources of the transistors Q3 and Q10 by means of a contact 52, and to a source of a transistor Q9 by means of a contact 54.

A drain of the transistor Q9 is connected to a source of the transistor Q8. The gates of the transistors Q1 and Q3 are connected to a polysilicon gate connection A1. The gates of the transistors Q5 and Q8 are connected to a polysilicon gate interconnection A2. The polysilicon gate interconnection A1 and A2 are connected to each other (not shown in Fig. 1). The gates of the transistors Q2 and Q4 are connected to a polysilicon gate interconnection B1, and the gates of the transistors Q6 and Q9 are connected to a polysilicon gate interconnection B2. The polysilicon interconnections B1 and B2 are also connected to each other (not shown in Fig. 1).

In the complementary semiconductor device 20 thus constructed, the polysilicon interconnections A1, A2, B1 and B2 are arranged so as not to cross the impurity layer. Therefore, as the number of contacts between the impurity layer and the aluminum interconnection are increased, an area necessary for the semiconductor device are increased. For example, a size (L1 × L2) of the prior complementary semiconductor device 20 is 82 μ × 76 μ.

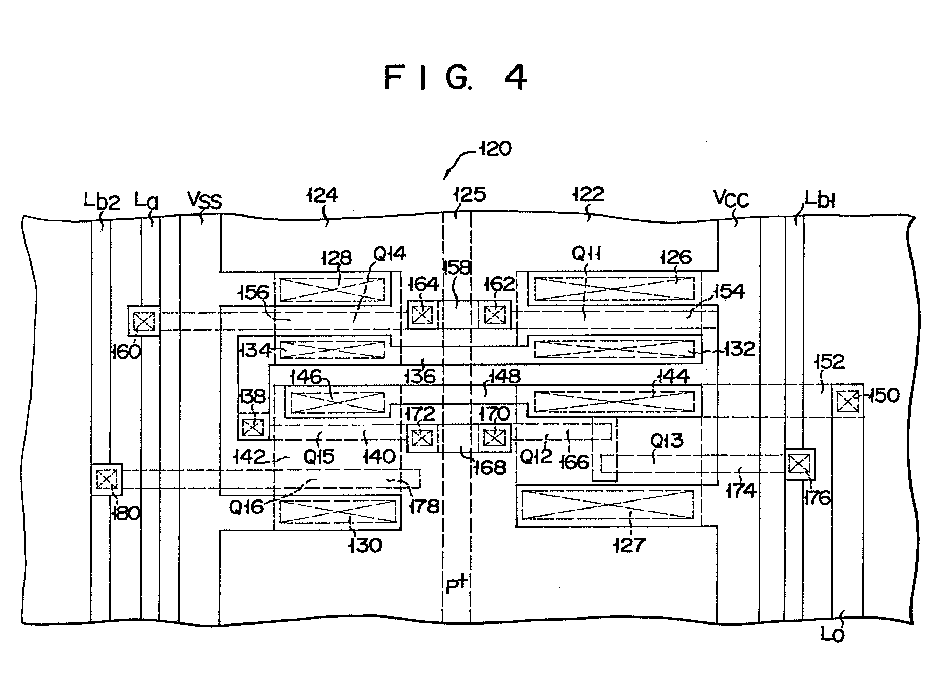

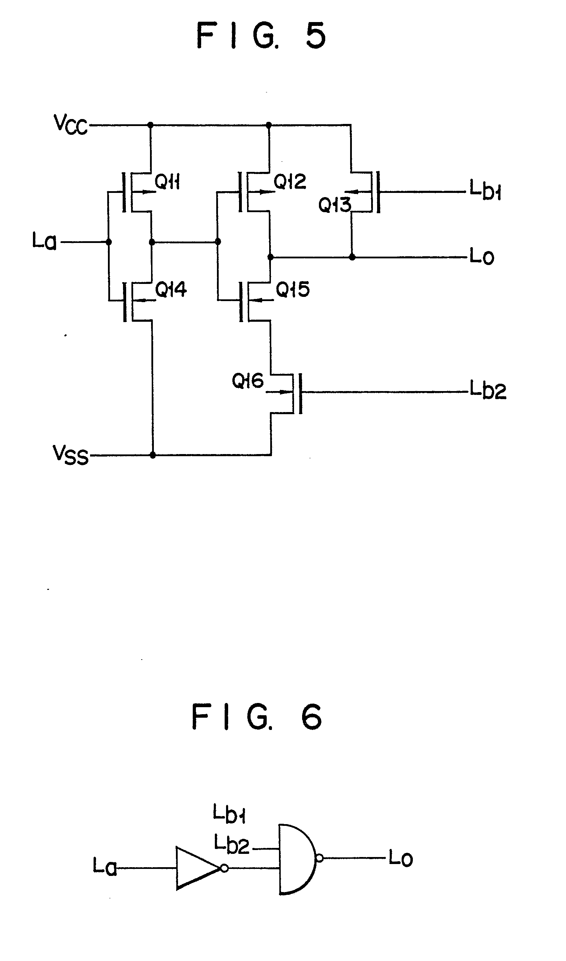

Another example of a semiconductor device formed by a prior method will be described referring to Figs. 4 and 6. Fig. 4 shows a plan view of a prior complementary semiconductor device 120. Fig. 5 shows a circuit diagram of the semiconductor device 120. Fig. 6 shows a logic expression of the circuit of the semiconductor device 120. The complementary semiconductor device 120 is comprised of P channel transistors Q11, Q12 and Q13 formed in an N type semiconductor device 122, and N channel transistors Q14, Q15 and Q16 formed in a P-well region 124 of the N type semiconductor substrate 122. A guard ring 125 of P type is formed around the P-well region 124.
A source of the P channel transistor Q11 is connected to
a power source line Vcc by means of a contact 126.
Sources of the P channel transistors Q12 and Q13 are
connected to a power source line Vcc by means of a contact 127. Sources of the N channel transistors Q14 and
Q16 are connected to a ground line Vss by means of contacts 128 and 130, respectively. A contact 132 for a
drain of the P channel transistor Q11 and a contact 134
for the N channnel transistor Q14 are connected to an
aluminum interconnection 136. The aluminum interconnection 136 is connected to a polysilicon gate 140 of
the N channel transistor Q15 by means of a contact 138.
A source of the N channel transistor Q15 and a drain of
the N channel transistor Q16 are formed by a single
impurity layer. A contact 144 for the P channel transistors Q12 and Q13 and a contact 146 for the N channel
transistor Q15 are connected by an aluminum interconnection 148. Drains of the P channel transistors Q12 and
Q13 are connected to an output line Lo by means of a
contact 150, through a diffusion interconnection layer
152. A polysilicon gate 154 of the P channel transistor
Q11 is connected to a polysilicon gate 156 of the N
channel transistor Q14 through an aluminum interconnection 158. The polysilicon gate 154 of the N channel
transistor Q14 is connected to an input line La by means
of a contact 160. The aluminum interconnection 158 is
connected to the polysilicon gates 154 and 156 by means
of contacts 162 and 164. A polysilicon gate 166 of the P
channel transistor Q12 is connected to a polysilicon gate
140 of the N channel transistor Q15 by means of an
aluminum interconnection 168. The aluminum interconnection 168 is connected to the polysilicon gates 166 and
140 by means of contacts 170 and 172, respectively. A
polysilicon gate 174 of the P channel transistor Q13 is
connected to an input line Lb1 by means of a contact 176
and a polysilicon gate 178 of the N channel transistor Q16 is connected to the input line Lbl by means of a contact 180.

In the complementary semiconductor device 120 thus constructed, a guard ring 125 of $P^+$ type crosses the aluminum interconnections 158 and 168. It would be easily formed by extending the polysilicon gates 154 and 156, and the polysilicon gates 140 and 166 into integral form, respectively. As described above, however, the $P^+$ type guard ring 125 can not be formed after the polysilicon gates are formed in the integral form. Therefore, the $P^+$ type guard ring 125 must be formed before the polysilicon gates are formed. In this case, the interconnection capacity is increased, as previously stated. For this reason, in the prior art manner, the polysilicon gates 154, 156, 166 and 140 are connected to one another by means of the aluminum interconnections, as shown in Fig. 4.

In the prior complementary semiconductor device 120 shown in Fig. 4, input lines Lbl and Lb2 for supplying the same potential are separately formed. It is for this reason that when the impurity is diffused by using the polysilicon gate interconnection as a mask, it is impossible to cross an impurity diffusion region with the polysilicon gates. It is for another reason that the number of process steps is increased. As a result, an area occupied by the semiconductor device is increased.

Accordingly, an object of the present invention is to provide a semiconductor device which allows a free crossing of an impurity diffusion layer and an interconnection layer made of refractory metal, thereby to improve an integration density.

To achieve the above-mentioned object, in the present invention, at least a part of an insulating layer is buried in a predetermined region of a semiconductor region of the first conductivity type. An interconnection layer made of refractory metal, which is integral with a gate electrode of a MOS transistor, is formed on the insulating layer. An impurity diffusion layer of a second conductivity type is formed right under and in contact with the insulating layer.

Such a construction allows a free crossing of the metal interconnection layer integral with the gate electrode of the MOS transistor and the high density impurity diffusion layer. Therefore, the high density impurity diffusion layers can be connected to each other by means of the high density impurity diffusion layer, unlike the prior method by which those are connected through an aluminum interconnection. Accordingly, an integration density of the semiconductor can be improved.

As mentioned above, it is possible to cross the metal interconnection layer with the high density impurity diffusion layers as desired. Therefore, an input interconnection pattern is simplified to form a crossing interconnection suitable for a high operation speed. As a result the integration density can be increased.

Other objects and advantages of the invention will become apparent from the following detailed description when taken in conjunction with the accompanying drawings in which:

Fig. 1 is a plan view of a prior complementary semiconductor device;

Fig. 2 is a circuit diagram of the complementary semiconductor device shown in Fig. 1;

Fig. 3 is a logic circuit diagram of the complementary semiconductor device shown in Fig. 1;

Fig. 4 is a plan view of another complementary semiconductor device of the prior art;

Fig. 5 is a circuit diagram of the complementary semiconductor device shown in Fig. 4;

Fig. 6 is a logic circuit diagram of the complementary semiconductor device shown in Fig. 4;

Figs. 7A to 7E are a series of plan views of a semiconductor device according to the present invention and a method for manufacturing the semiconductor device;

Figs. 8A to 8E are a series of cross sectional views taken on lines VIIIA - VIIIA, VIIIB - VIIIB, VIIIC - VIIIC, VIIID - VIIID and VIIIE - VIIIE shown in Figs. 7A to 7E, respectively;

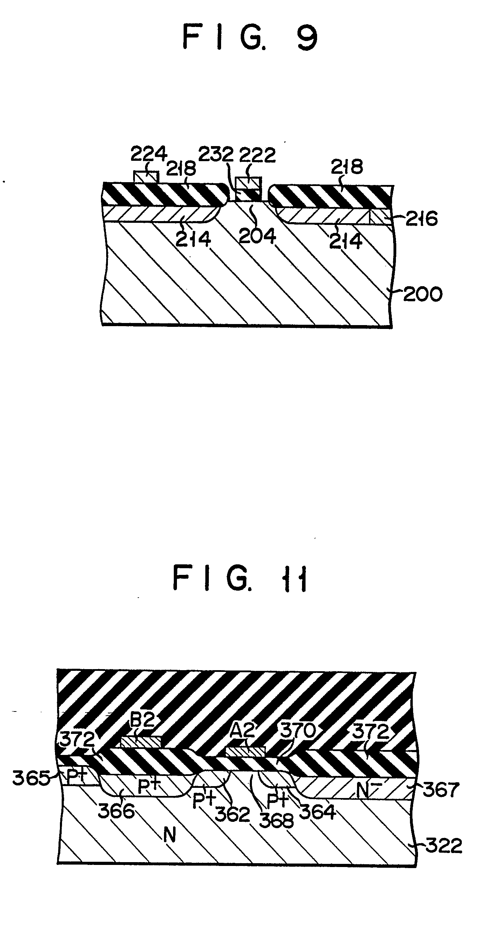

Fig. 9 is a cross sectional view for explaining another manufacturing method of a semiconductor device according to the present invention;

Fig. 10 is a plan view of a complementary semiconductor device according to the present invention;

Fig. 11 is a cross sectional view taken on line XI - XI in Fig. 10;

Fig. 12 is a plan view of another complementary semiconductor device according to the present invention;

Fig. 13 is a cross sectional view taken on line XIII - XIII shown in Fig. 12;

Fig. 14 is a cross sectional view taken on line XIV - XIV shown in Fig. 12; and

Figs. 15A to 15J are cross sectional views useful in explaining a manufacturing method of a complementary semiconductor device according to the present invention.

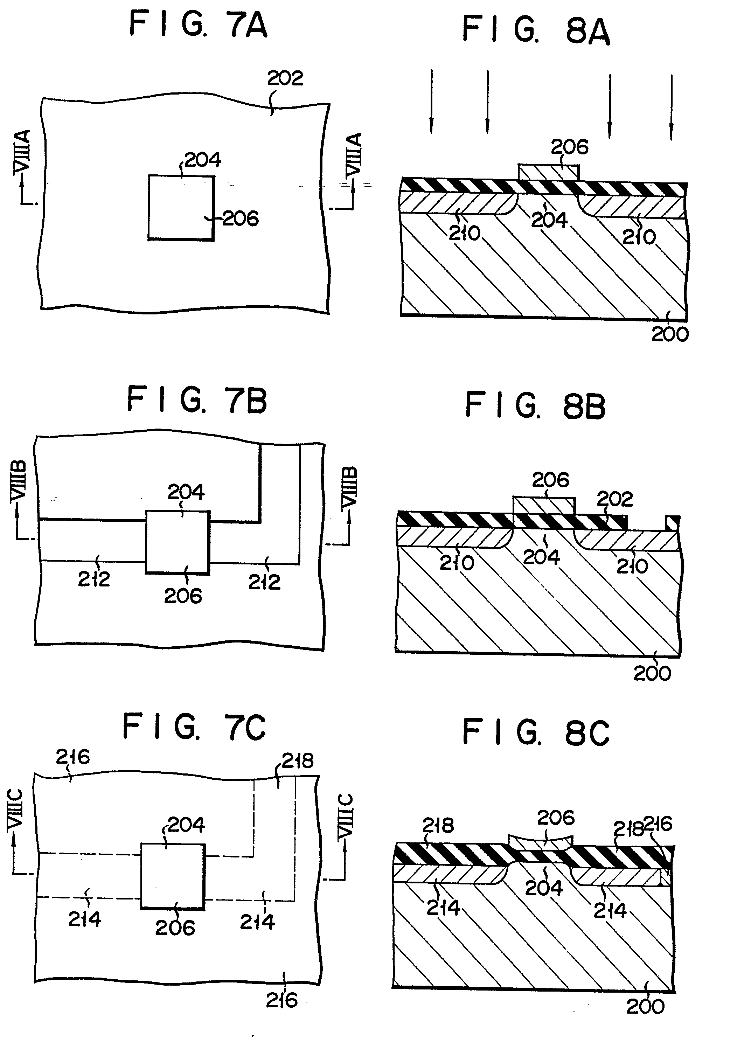

An embodiment of the present invention will be described referring to Figs. 7A to 7E and Figs. 8A to 8E. Figs. 7A to 7E are plan views of a semiconductor device according to the present invention. Figs. 8A to 8E are cross sectional views taken on lines VIIIA - VIIIA, VIIIB - VIIIB, VIIIC - VIIIC, VIIID - VIIID and VIIIE - VIIIE shown in Figs. 7A to 7E, respectively. As a first step, a silicon oxide film 202 with a predetermined film thickness is formed on the surface of a semiconductor substrate 200 made of silicon, as shown in Figs. 7A and 8A. As a second step, a protective film 206 for selective oxidation is formed on a part of the oxide film 202 corresponding to an element region 204 of the semiconductor substrate 200. Then, an impurity layer 210 is formed in a part of the semiconductor substrate 200 except the element region 204, with a mask of the protective film 206, by implanting ions of impurity 208 of the same conductivity type as that of the semiconductor substrate 200.

An impurity concentration of the impurity layer 200 injected with ions is satisfactory to such an amount as to not form an undesirable parasitic field effect transistor under an element separation insulating layer enclosing the element region 204.

Then, as shown in Figs. 7B and 8B, the silicon oxide film 202 on a region continuous to the element region 204, in which an L-shaped buried interconnection layer is to be formed, is selectively etched.

Then, as shown in Figs. 7C and 8C, with a mask of the protective film 206 and the remains of the silicon oxide film 202, impurity of the opposite conductivity type to that of the semiconductor substrate 200 is introduced into the region 212 in which the buried type interconnection layer is to be formed, by a thermal diffusion process or an ion implantation process to form a buried interconnection layer 214. The impurity layer 210 on which the buried interconnection layer 214 is not formed, serves as an inversion preventing layer 216. Further, it is necessary to select an impurity concentration for forming the buried interconnection layer 214 higher than that of the impurity for forming the impurity layer 210, in order to make the conductivity type of the buried interconnection layer 214 opposite to that of the inversion preventing layer 216. In the next step, an element separation insulating layer 218 surrounding the element region 204 is formed by selectively thermally oxidizing the semiproduct, with a mask of the protective film 206. By the thermal oxidization, the element separation insulating layer 218 is partially buried in the semiconductor substrate 210. Right under the element separation insulating layer 218, there are the buried interconnection layer 214 and the inversion preventing layer 216. By the way, since the element separation insulating layer 218 is selectively formed by using the protective film 206 as a mask, the element region 204, the element separation insulating layer 218, the buried interconnection layer 214 and the inversion preventing layer 216 are self-aligned around the protective film 206. The buried interconnection layer 214 and the inversion preventing layer 216 may be formed by forming a resist film (not shown) over a part of the silicon oxide film 202 corresponding to a predetermined region for forming the inversion preventing layer, instead of etching the silicon oxide film 202 selectively, and implanting ions by using the resist film as a mask.

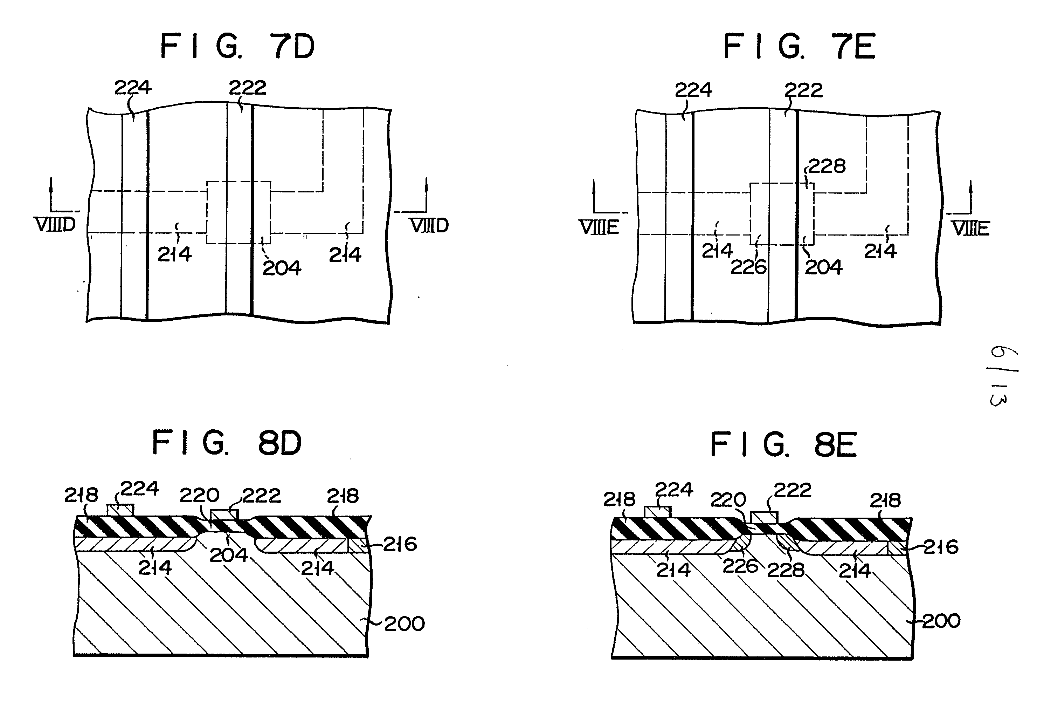

Subsequently, as shown in Figs. 7D and 8D, after removing the protective film 206, a polysilicon gate interconnection 222 is formed on a gate oxide film 220 over the element region 204. Further, a polysilicon gate interconnection 224 of another MOS transistor is formed on a predetermined region of the element separation insulating layer 218.

Then, as shown in Figs. 7E and 8E, impurity of the opposite conductivity type to that of the semiconductor substrate 200 is introduced into the element region, by using the polysilicon gate interconnection 222 and the element separation insulating layer 218 as a mask, thereby to form a source diffusion layer 226 and a drain duffusion layer 228. At this stage, a semiconductor device 230 is completed. As the element separation insulating layer 218 is formed relatively thick, the impurity is not introduced into the buried interconnction layer 214.

Besides, the source diffusion layer 226 and the drain diffusion layer 228 may be formed in a manner that a gate oxide film 232 is formed by selectively etching the semiproduct by using the polysilicon gate interconnection 222 as a mask, and the impurity is introduced into the substrate 200 by the thermal diffusion process, while using the polysilicon gate interconnection 222 and the gate oxide film 232 as a mask.

In the semiconductor device 230 thus constructed, the buried interconnection layer 214 having the diffused impurity of the opposite conductivity type to that of the semiconductor substrate and the inversion preventing layer 216 having the diffused impurity of the same conductivity type as that of the semiconductor substrate are self-aligned with the element region 204 in which the field effect transistor is formed. Further, the buried interconnection layer 214 and the inversion preventing layer 216 are self-aligned with the source diffusion layer 226 and the drain diffusion layer 228 at the boundary of the element separation insulating layer 218 buried in the semiconductor substrate 200. The buried interconnection layer 214 and the inversion preventing layer 216 are self-aligned with each other by the mask used when the buried interconnection layer 214 is formed. Further, with such a structure of the semiconductor device, the formation of a parasitic MOS transistor is prevented. With the relatively thick element separation insulating layer 218 intervening between the polysilicon gate interconnection 224 and the buried interconnection layer, it is possible to cross the polysilicon gate interconnection 224 and the buried interconnection layer 214 each other at a desirable arrangement. As a result, an integration density of the semiconductor device 230 is improved.

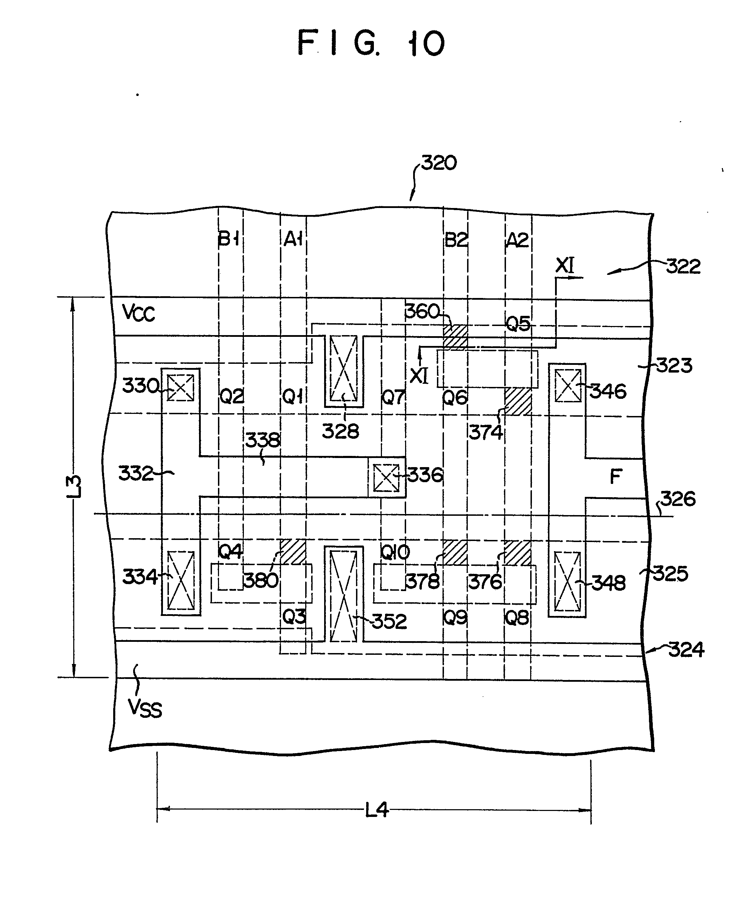

An improved embodiment of the conventional complementary semiconductor device 20 shown in Fig. 1 will next be described referring to Fig. 10. Fig. 10 is a plan view of a complementary semiconductor device 320 according to the present invention. A circuit diagram and a logic circuit diagram are similar to those of Figs. 2 and 3, respectively. The complementary semiconductor device 320 includes P channel transistors Q1, Q2, Q5, Q6 and Q7 formed in an element group region 323 of a semiconductor substrate 322 and N channel transistors Q3, Q4, Q8, Q9 and Q10 formed in an element group region 325 of a P-well region 324. The boundary of the P-well region 324 and the N type semiconductor substrate 322 is indicated by a line 326. Sources of the P channel transistors Q1 and Q7 are connected to a power source line Vcc by means of a contact 328. A drain of the transistor Q1 is coupled with a source of the transistor Q2. A drain of the transistor Q2 is connected with an aluminum interconection 332 by a contact 330. The aluminum interconnection 332 is connected with drains of the transistors Q3 and Q4 by a contact 334 and with polysilicon gate interconnection 338 of the transistors Q7 and Q10 by a contact 336.

A drain of the transistor Q7 is connected to a source of the transistor Q5 through a buried interconnection layer (a high density impurity diffusion layer) to which the present invention applied, and which resides in a portion 360 shown by oblique lines. Fig. 11 is a partial cross sectional view of the semiconductor device 320 taken on line XI - XI in Fig. 10. Specifically, a $P^+$ type source diffusion layer 362 and a $P^+$ type drain diffusion layer 364 of the transistor Q5, a $P^+$ type drain diffusion layer 365 of the transistor Q7, a $P^+$ type buried interconnection layer 366 and an $N^-$ type inversion preventing layer 367 are formed in the N type semiconductor substrate 322. On a substrate region 368 where a channel is formed, a silicon gate oxide film 370 is formed. On the silicon gate oxide film 370, a polysilicon gate interconnection A2 is disposed. Further, a thick silicon oxide film 372 is formed on the $P^+$ type buried interconnection layer 366, and a polysilicon gate interconnection B2 is formed on the silicon oxide film 372. Besides, the silicon oxide film 372 is so formed as to be partially buried into the semiconductor substrate 322.

A drain of the transistor Q7 is connected with a source of the transistor Q6. A drain of the transistor Q6 is coupled with a drain of the transistor Q5 by way of a buried inter connection layer existing in a portion 374 indicated by oblique lines to which the present invention is applied. As the portion 374 indicated by the oblique lines has substantially the same construction as that shown in Fig. 11, hence the explanation of it will not be described. Drains of the transistors Q5 and Q6 are connected to an output interconnection F of the complementary semiconductor device 320 by a contact 346. The output interconnection F is connected with a drain of the transistor Q8 by a contact 348. A drain of the transistor Q8 is connected to a drain of the transistor Q10 via a buried interconnection layer existing at portions 376 and 378 as indicated by the oblique lines to which the present invention is applied. Since the oblique-lined portions 376 and 378 also have substantially the same construction as that shown in Fig. 11, those will not be described any more. Further, a ground line Vss is connected with sources of the transistors Q3 and Q10 by a contact 352. The sources of the transistors Q3 and Q10 are also connected with a source of the transistor Q4 through a buried interconnection layer existing at a portion 380 indicated by oblique lines where the present invention is applied. As the portion 380 indicated by oblique lines has also substantially the same construction as that shown in Fig. 11, no further explanation will be described. Gates of the transistors Q1 and Q3 are connected to a polysilicon gate interconnection A1, and gates of the transistors Q5 and Q8 are connected to a polysilicon gate interconnection A2. The polysilicon intercon- nections A1 and A2 are connected each other (not shown in Fig. 10). Gates of the transistors Q2 and Q4 are connected to a polysilicon gate interconnection B1. Gates of the transistors Q6 and Q9 are connected with a polysilicon gate interconnection B2. The polysilicon

gate interconnections B1 and B2 are connected to each other (not shown in Fig. 10).

In the semiconductor device 320 thus constructed, the high concentration impurity diffusion layers may be interconnected by the buried interconnection layer, not by the aluminum interconnection as in the case of the semiconductor device 20 shown in Fig. 1. The interconnection pattern, therefore, is simple and hence the integration desity of the semiconductor device is high. For example, a dimension (L3 × L4) of the semiconductor device 320 of the present embodiment is 60 μ × 70 μ = 4,200 $\mu^2$. Its area is reduced by 30% compared to the prior art semiconductor device 20.

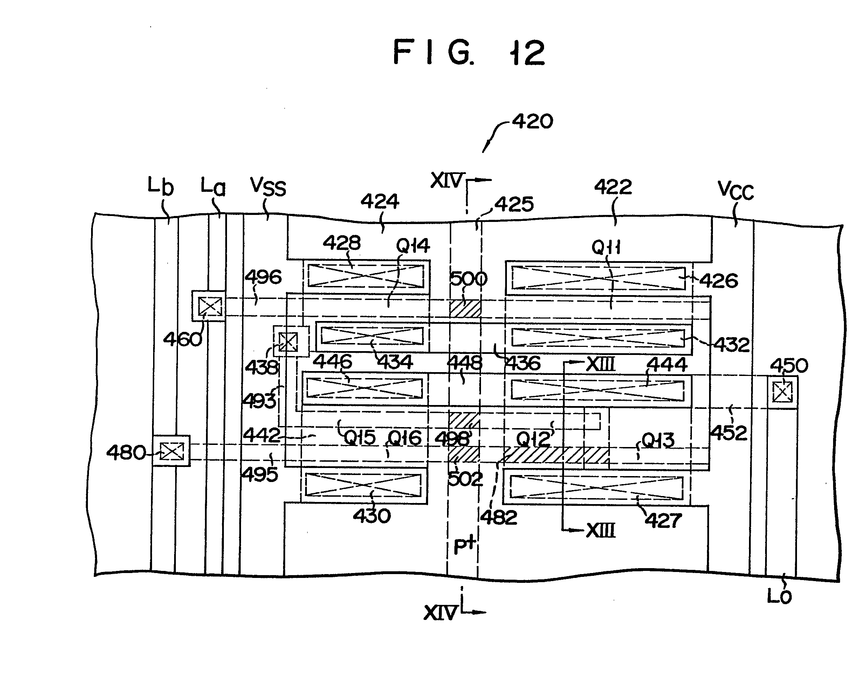

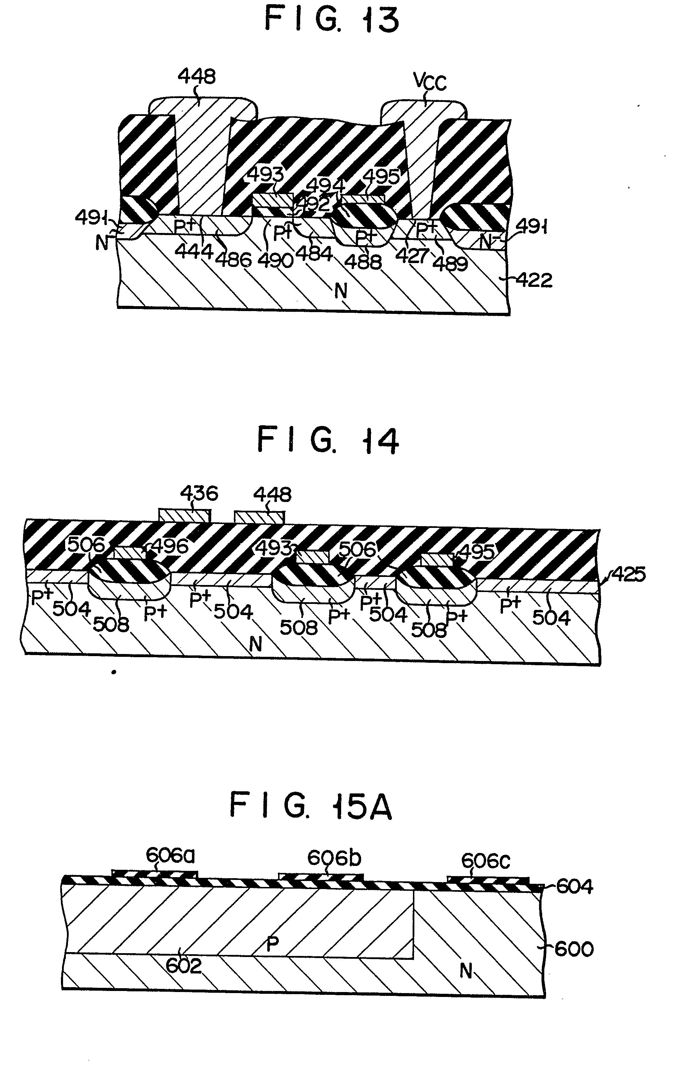

An improved example of the prior complementary semiconductor device 120 shown in Fig. 4 will be described, with reference to Fig. 12. Fig. 12 is a plan view of a complementary semiconductor device according to the present invention. A circuit diagram and a logic circuit of the complementary semiconductor device 420 are the same as those in Figs. 4 and 5, respectively. The complementary semiconductor device 420 is comprised of P channel transistors Q11, Q12 and Q13 formed in an N type semiconductor substrate 422 and N channel transistors Q14, Q15 and Q16 formed in a P-well region 424. A guard ring 425 of $P^+$ type is formed around the P-well region 424. A source of the P channel transistor Q11 is connected to a power source line Vcc by means of a contact 426. A source of the P channel transistor Q13 is connected to the power source line Vcc by means of a contact 427. A source of the transistor Q12 is connected to the power source line Vcc through a buried interconnection layer residing in an oblique-lined portion 482 to which the present invention is applied. Fig. 13 shows a cross sectional view taken on line XIII - XIII of Fig. 12. As shown, formed in the N type semiconductor substrate 422 are a $P^+$ type source diffusion layer 484 and a $P^+$ type drain diffusion layer 486 of the transistor Q12, a $P^+$ type buried interconnection layer 488, a $P^+$ type diffusion interconnection layer 489, and an $N^-$ type inversion preventing layer 491. A silicon gate oxide film 492 is formed on a substrate region 490 in which a channel is to be formed, and a polysilicon gate interconnection 493 for the transistors Q12 and Q15 is formed on the silicon gate oxide film 492. A thick silicon oxide film 494 is formed on a $P^+$ type buried interconnection layer 488 on which a polysilicon gate interconnection 495 of the transistors Q13 and Q16 is further formed. The silicon oxide film 494 is partially buried in the semiconductor substrate 422. A diffusion interconnection layer 489 is connected to the power source line Vcc by means of a contact 427, and a drain of the transistor Q12 is connected to an aluminum interconnection 448 by means of a contact 444.

Sources of N channel transistors Q14 and Q16 are connected to a ground line Vss by means of contacts 428 and 430. A contact 432 for a drain of the P channel transistor Q11 and a contact 434 for a drain of the N channel transistor Q14 are interconnected by means of an aluminum interconnection 436. A drain of the transistor Q14 is connected to a polysilicon interconnection 493 which functions as gates of the transistors Q12 and Q15. A source of the N channel transistor Q15 and a drain of the N channel transistor Q16 are formed by the same impurity layer 442. A contact 444 for the drains of the P channel transistors Q12 and Q13 is interconnected with a contact 446 for a drain of the N channel transistor Q15, by means of an aluminum interconnection 448. Drains of the P channel transistors Q12 and Q13 is connected to an output line Lo through a diffusion interconnection 452, by means of a contact 450. Gates of the P channel transistor Q11 and the N channel transistor Q14 are integrally formed by a polysilicon interconnection 496.

The polysilicon interconnections 493, 495 and 496 and the $P^+$ type guard ring 425 cross at the slanted line portions 498, 500 and 502. Note that the present invention is applied to the slanted line portions 498, 500 and 502, too. Fig. 14 is a cross sectional view taken on line XIV - XIV in Fig. 12. A $P^+$ type guard ring 425 is formed in the N type semiconductor substrate 422. The guard ring 425 is comprised of a diffusion layer 504 formed on the surface of the N type semiconductor substrate 425, and a $P^+$ type buried layer 508 formed under a relatively thick silicon oxide film 506 and partially buried in the semiconductor substrate 425. Formed on the silicon oxide film 506 are a polysilicon gate interconnection 496 of the transistors Q11 and Q14, a polysilicon gate interconnection 493 of the transistors Q12 and Q14, and a polysilicon gate interconnection 495 of the transistors Q13 and Q16. The structure as mentioned above prevents a great stray capacitor from being formed between the polysilicon gate interconnections 493, 495 and 496 and the $P^+$ type buried layer 508. The gates of a couple of transistors may integrally be formed by the polysilicon gate interconnections 493, 495 and 496, not by connecting the aluminum interconnection as in the case of the complementary semiconductor device 120 of Fig. 4. This feature improves an integration density.

The polysilicon gate interconnection 496 of the transistors Q11 and Q14 is connected to an input line La by means of a contact 460, and the polysilicon gate interconnection 495 of the transistors Q13 and Q16 is connected to an input line Lb by means of a contact 480. This structure eliminates a need for providing input lines Lb1 and Lb2 of the transistors Q13 and Q16, unlike the prior complementary semiconductor device 120.

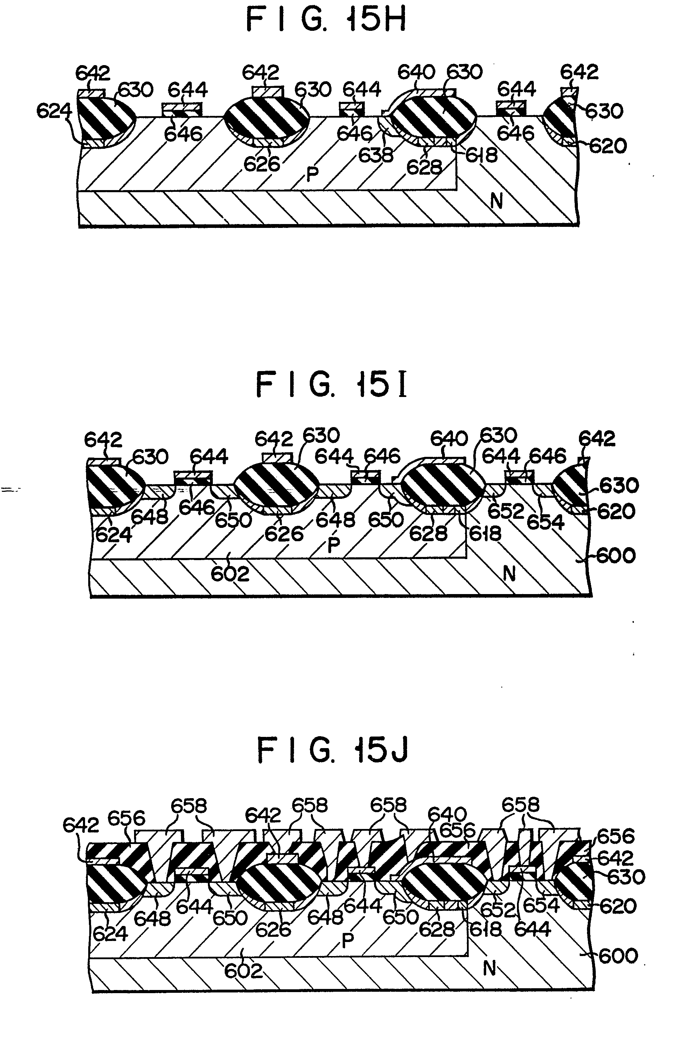

A manufacturing method of a general complementary semiconductor device according to the present invention will be described referring to Figs. 15A to 15J. To start, boron ($B^{+11}$) as impurity is ion-implanted into a given region of the N type semiconductor substrate 600, thereby to form a P-well layer 602. An oxide film 604 is formed over the entire surfaces of the P-well layer 602 and the N type semiconductor substrate 600. A silicon nitride film ($Si_3N_4$) is formed on the oxide film 604 and is selectively etched by a photoetching method, thereby forming silicon nitride patterns 606a, 606b and 606c.

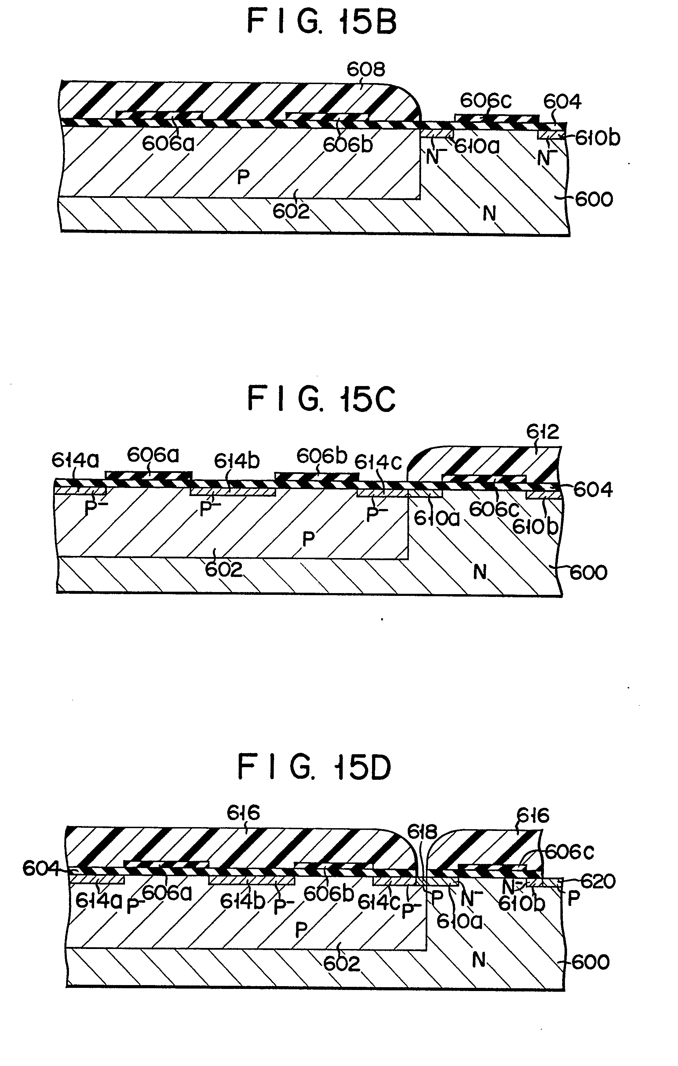

As shown in Fig. 15B, a resist film 608 is coated over the silicon nitride patterns 606a and 606b and the oxide film 604 on the P-well layer 602. With a mask of the resist film 608 and the silicon nitride pattern 606c, $N^-$ type impurity for the inversion prevention is ion-implanted into the N type semiconductor substrate 600, thereby forming channel stoppers 610a and 610b.

As shown in Fig. 15C, the resist film 608 on the P-well layer 602 is removed and a resist film 612 is coated over the oxide film 604 and the silicon nitride pattern 606c on the semiconductor substrate 600. With a mask of the resist film 612 and the silicon nitride patterns 606a and 606b on the P-well layer 602, $P^-$ type impurity for the inversion prevention is ion-implanted into the P-well layer 602, thereby to form channel stopper layers 614a, 614b and 614c in the P-well layer 602. Then, the resist film 612 is removed.

Then, as shown in Fig. 15D, the resist film 616 is selectively formed, an opening is formed in an oxide film 604 not having the resist film 616, and P type impurity is diffused into the $N^-$ and $P^-$ type channel stopper layers 610b and 614c, thereby forming buried interconnection layers 618 and 620. The reason why the impurity implantation step follows the opening step of the oxide film 604 is that traces of the buried interconnection layers 618 and 620 must be left and that high concentration but low resistive buried interconnection layers 618 and 620 must be formed by implanting ions more deeply than in the case of not opening the oxide film 604 and by a heat treatment such as an oxidizing step, for example, to be given later. A shape of the pattern of the resist film 616 may be so selected as to cover the silicon nitride films 606a, 606b and 606c, allowing for the misalignment. The reason for this is that the source and drain of the transistor to be formed in the element region in the later process step is connected to the buried interconnection layer in a self-alignment fashion by the element separation insulating layer.

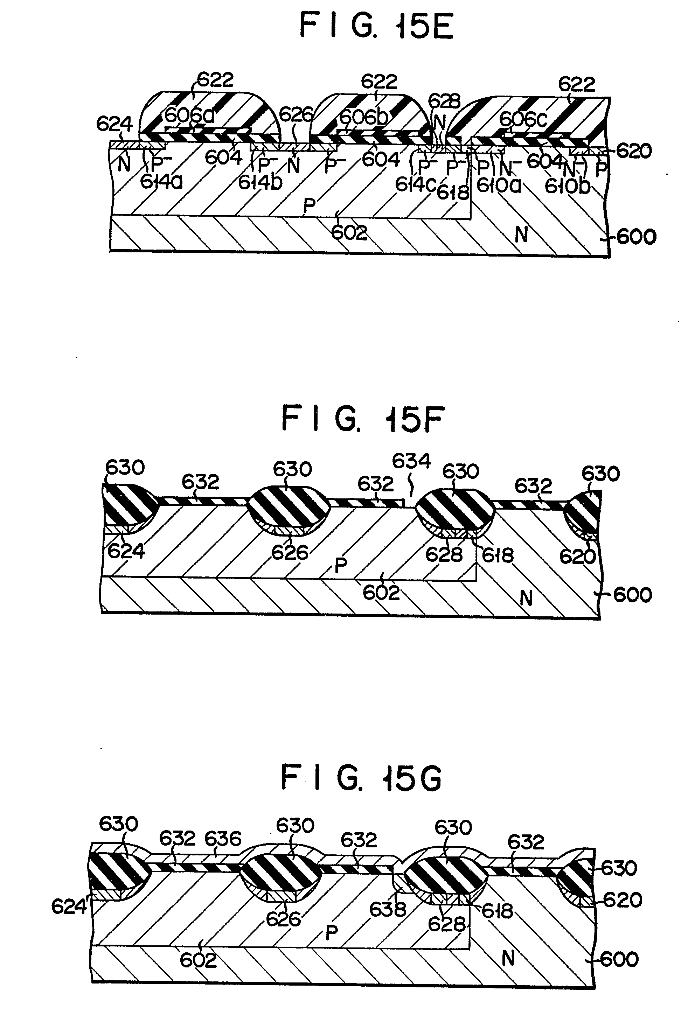

In the following step, the resist film 616 is removed, as shown in Fig. 15E, and a new resist film 622 is selectively formed again. Then, an opening is formed in an oxide film 604, as in the step of Fig. 15D, and N type impurity is ion-implanted into $P^-$ type channel stopper layers 614a, 614b and 614c, thereby to form buried interconnection layers 624, 628 and 630.

In the next step, as shown in Fig. 15F, the resist film 622 is removed and the heat treatment is performed with a mask of the silicon nitride patterns 606a, 606b and 606c, thereby to form an element separation insulating layer 630 buried in predetermined regions of the P-well layer 602 and the semiconductor substrate 600. Then, the silicon nitride patterns 606a, 606b and 606c and the oxide film 604 are removed. Following this, an oxide film 632 is formed on the exposed semiconductor substrate 600 and the P-well layer 602. An opening 634 is formed in a part of the oxide film 632.

As shown in Fig. 15G, a polysilicon film 636 is then formed on the surfaces of the oxide film 632 and the element separation insulating layer 630. Subsequently, impurity such as phosphorus is diffused from its surface by using phosphorus oxychloride ($POCl_3$), for example, through the opening 634, thereby to form an N type diffusion layer 638 in the element region of the P-well 602, while rendering the polysilicon film 636 the N conductivity type.

In the next step, as shown in Fig. 15H, the polysilicon film 636 is selectively etched by the photoetching method, thereby forming an interconnection layer 640 directly connected to the diffusion layer, an interconnection 642 on the element separation insulating layer 630, and a gate electrode 644. Further, the oxide film 632 is etched with a mask of the gate electrode 644, thereby to form a gate oxide film 646.

Subsequently, as shown in Fig. 15I, by using the gate electrode 644 as a mask, N type impurity is diffused into the element region of the P-well layer 602 to form the $N^+$ type source region 648 and a drain region 650. P type impurity is diffused into the element region of the semiconductor substrate 600 to form a $P^+$ type source region 652 and a drain region 654.

Then, as shown in Fig. 15J, an oxide film 656 is formed over the entire surface thereof. The oxide film is selectively opened, and the lead-out electrode 658 is coupled with the source regions 648 and 652, the drain regions 650 and 654, the gate electrode 644, the interconnection 640 and the interconnection 642. In this way, the complementary semiconductor device is completed.

If the complementary device is formed by the above-mentioned method, the given diffusion layers may directly be connected each other with the shortest possible interval through the buried interconnections 618, 620, 624, 626 and 628 provided right under the element separation insulating layer. As a result, an integration density of the semiconductor device can remarkably be improved.

Claims:

1. A semiconductor device characterized by comprising:

a first semiconductor element formed in a semiconductor region of a first conductivity type, and having a gate electrode made of refractory metal and an impurity region of a second conductivity type;

a first insulating layer at least partially buried in a predetermined region of said semiconductor region, a metal interconnection layer integral with said gate electrode being formed on said first insulating layer; and

a first impurity diffusion layer formed in said semiconductor region right under said first insulating layer, in contact with said first insulating layer, and having impurity of a second conductivity type.

2. The semiconductor device according to claim 1, characterized in that, right under said first insulating layer, a first inversion preventing layer of a first conductivity type is formed in contact with said first impurity diffusion layer and said impurity region of said first semiconductor element.

3. The semiconductor device according to claim 1 or 2, characterized in that said first semiconductor element is a field effect transistor, and said first impurity diffusion layer is connected to said impurity region of said field effect transistor.

4. The semiconductor device according to claim 1 or 2, characterized in that said first impurity diffusion layer is connected with power source diffusion layer formed in the semiconductor region in order to supply voltage.

5. The semiconductor device according to claim 1, characterized in that a well layer of a second conductivity type is futher formed in said semiconductor region of the first conductivity type, which comprises:

a second semiconductor element having a gate electrode made of refractory metal and an impurity region of a first conductivity type;

a second insulating layer at least partially buried in a predetermined region of said well layer, a metal interconnection layer integral with said gate electrode of said second semiconductor element being formed on said second insulating layer; and

a second impurity diffusion layer formed in said well layer right under said second insulating layer, in contact with said insulating layer, and having impurity of the first conductivity type.

6. The semiconductor device according to claim 5, characterized in that, right under said second insulating layer, a second inversion preventing layer of the second conductivity type is formed in contact with said second impurity diffusion layer and said impurity region of said second semiconductor element.

7. The semiconductor device according to claim 5 or 6, characterized in that said second semiconductor element is a field effect transistor, and said second impurity diffusion layer is connected to a source region or a drain region of said field effect transistor, or a power source diffusion layer for supplying voltage.

8. The semiconductor device according to claim 5 or 6, characterized in that said second impurity diffusion layer is connected with a power source diffusion layer formed in said well layer in order to supply voltage.

9. A method for manufacturing a semiconductor device characterized by comprising the steps of:

selectively forming a first impurity diffusion layer of a second conductivity type in a semiconductor region of a first conductivity type;

forming a first insulating layer at least partially buried in said first impurity diffusion layer by thermal oxidation of said first impurity diffusion layer;

forming a metal interconnection layer made of refractory metal on said first insulating layer; and

introducing impurity of a second conductivity type into said semiconductor region by using said first insulating layer as a mask, thereby forming a first impurity region connected to said first impurity diffusion layer in a self-alignment manner.

10. The method according to claim 9, characterized in that right under said first insulating layer, a first inversion preventing layer of a first conductivity type is formed in a self-alignment with said first impurity diffusion layer and said first impurity region.

11. The method according to claim 9 or 10, characterized by comprising the steps of:

forming a well layer of a second conductivity type in the semiconductor region of a first conductivity type;

selectively forming a second impurity diffusion layer of a first conductivity type in said well layer;

forming a second insulating layer at least partially buried in said second impurity diffusion layer by the thermal oxidation of said second impurity diffusion layer;

forming a metal interconnection layer made of refractory metal on said second insulating layer; and

introducing impurity of a first conductivity type into said well layer by using said second insulating layer as a mask, thereby forming a second impurity region connected to said second impurity diffusion layer in a self-alignment manner.

12. The method according to claim 11, characterized in that right under said second insulating layer, a second inversion preventing layer of a second conductivity type is formed in a self-alignment with said second impurity diffusion layer and said second impurity region.

0052475

# F I G. 1

# FIG. 2

# FIG. 3

$$F = \bar{A} \cdot B + A \cdot \bar{B}$$

# FIG. 4

# F I G. 5

# F I G. 6

FIG. 7A

FIG. 8A

FIG. 7B

FIG. 8B

FIG. 7C

FIG. 8C

FIG. 7D

224    222

VIIID          VIIID

214    204    214

FIG. 7E

224    222

228

VIIIE          VIIIE

214    226    204    214

FIG. 8D

218  224  220  222  218

216

214    204    214

200

FIG. 8E

218  224  220  222  218

216

214  226  228  214

200

6/13

0052475

0052475

# FIG. 9

# FIG. 11

# F I G. 10

# FIG. 12

# FIG. 13

# FIG. 14

# FIG. 15A

# F I G. 15B

608
606c
604
606a
606b
N⁻
610a
N⁻
610b
P
600
602
N

# F I G. 15C

612
614a
606a
614b
606b
614c
604
P⁻
P⁻
P⁻
610a
606c
610b
P
602
N
600

# F I G. 15D

616
618
616
604
606c
614a
P⁻
606a
614b
P⁻
606b
614c
P⁻
P
N⁻
610b
P
620
P
610a
602
N
600

# F I G. 15E

622        622        622

624   606a    626    606b   628   606c

604    604    604    620

N   P⁻    P⁻ N   P⁻    P   P   N   N⁻   N   P

614a    614b    614c   618   610a    610b

P

602     N   600

# F I G. 15F

630    632    630    632   634   630    632    630

624    626    628   618    620

P

602    N   600

# F I G. 15G

630   632   636    630    632    630    632

630

624    626   638   628   618    620

P

602    N   600

# F I G. 15H

# F I G. 15I

# F I G. 15J